# EUROPEAN PATENT SPECIFICATION

(11) **EP 3 575 438 B1**
(45) Date of publication and mention of the grant of the patent: **10.11.2021**
(21) Application number: 18892002.9
(22) Date of filing: 19.12.2018
(51) Int. Cl.: C23C 14/34, B22F 3/10, C22C 1/04, C22C 1/05, C22C 9/00, H01L 31/0749

(54) **CU-GA ALLOY SPUTTERING TARGET AND METHOD FOR PRODUCING CU-GA ALLOY SPUTTERING TARGET**
CU-GA-LEGIERUNGS-SPUTTERTARGET UND VERFAHREN ZUR HERSTELLUNG DES CU-GA-LEGIERUNGS-SPUTTERTARGETS
CIBLE DE PULVÉRISATION EN ALLIAGE DE CU-GA ET PROCÉDÉ POUR PRODUIRE UNE CIBLE DE PULVÉRISATION EN ALLIAGE DE CU-GA

(30) Priority: 22.12.2017 JP 2017246339
(43) Date of publication of application: 04.12.2019
(73) Proprietor: Mitsubishi Materials Corporation, Tokyo 100-8117 (JP)
(72) Inventor: MORI Satoru, Saitama-shi, Saitama 330-8508 (JP); UMEMOTO Keita, Sanda-shi, Hyogo 669-1339 (JP); HASHIMOTO Shu, Sanda-shi, Hyogo 669-1339 (JP); TAKEDA Takuma, Naka-shi, Ibaraki 311-0102 (JP)
(74) Representative: Hoffmann Eitle
(86) International application number: PCT/JP2018/046750
(87) International publication number: WO 2019/124430

(56) References cited:
- WO-A1-2011/083647
- WO-A1-2014/129648
- WO-A1-2016/006600
- WO-A1-2017/138565
- JP-A- 2016 065 309
- JP-A- 2017 150 070

## Description

### TECHNICAL FIELD

The present invention relates to a Cu-Ga alloy sputtering target, for example, used when forming a Cu-In-Ga-Se compound film (hereinafter abbreviated as a CIGS film) to be a light absorption layer of a CIGS solar cell, and a method of manufacturing the Cu-Ga alloy sputtering target.

### BACKGROUND ART

In the related art, as a thin film solar cell formed of a compound semiconductor, a CIGS solar cell including a light absorption layer formed of a CIGS film is provided.

As a method of forming the light absorption layer formed of the CIGS film, a deposition method using a vapor deposition method is known. A solar cell including the light absorption layer deposited by the vapor deposition method has an advantage that an energy exchange efficiency is high. However, there was a problem in that it was unsuitable for increasing an area thereof and the production efficiency was low. In addition, there was a problem that uniformity in film thickness distribution was likely to be deteriorated.

Therefore, a method of forming the light absorption layer formed of the CIGS film by a sputtering method is proposed.

In the sputtering method, first, an In film is deposited using an In sputtering target, a Cu-Ga film is deposited on the In film by using a Cu-Ga sputtering target, and a laminated film of the In film and the Cu-Ga film is formed. Then, the CIGS film is formed by heat treating the laminated film in a Se atmosphere and selenizing the laminated film.

For example, as shown in NPL 1, it is known that when an alkali metal such as Na or K, is added to a CIGS film to be a light absorption layer, the conversion efficiency of a solar cell is improved.

As methods for adding the alkali metal to the CIGS film, for example, PTL 1 discloses that Na is added to a Cu-Ga alloy sputtering target used when a Cu-Ga film is deposited, and PTL 2 proposes that K is added to a Cu-Ga alloy sputtering target used when a Cu-Ga film is deposited.

PTL 3 relates to a sputtering target having a composition containing 5-60 atom% of Ga and 0.01-5 atom% of an alkali metal as metal components, the balance being Cu and unavoidable impurities, wherein the alkali metal concentration of the surface on the sputtering-surface side is less than 80% of the alkali metal concentration of the target interior.

Citation List

### Patent Literature

[PTL 1] Japanese Unexamined Patent Application, First Publication No. 2015-030870
[PTL 2] Japanese Unexamined Patent Application, First Publication No. 2016-050363
[PTL 3] WO 2017/138565 A1 (English translation published as EP 3 415 658 A1)

### Non-Patent Literature

[NPL 1] Adrian Chirila et; Potassium-induced surface modification of Cu(In,Ga)Se2 thin films for high-efficiency solar cells; NATURE MATERIALS, vol. 12, DECEMBER (2013)

### DISCLOSURE OF INVENTION

### Technical Problem

When adding Na or K to the sputtering target, selenides, sulfides, and the like can be used. However, since these compounds have extremely high hygroscopic properties, raw materials thereof needed to be managed when manufacturing the sputtering target.

Potassium fluoride (KF) has a hygroscopic property lower than that of selenides and sulfides, but has a property in that it relatively easily absorbs moisture. In a case where the potassium fluoride (KF) is added, when the sputtering target is stored in an atmosphere, moisture in the air is absorbed, and a surface of the sputtering target is oxidized and discolored. Therefore, there was a problem that a defect such as abnormal discharge during sputtering might occur. Therefore, it is necessary to store the sputtering target strictly, and there was a problem that process management in manufacturing a solar cell might be greatly hindered.

The present invention has been made in view of the above described circumstances. An object of the present invention is to provide a Cu-Ga alloy sputtering target in which Na and K are included, discoloration is suppressed even when stored in an atmosphere, and stable sputtering deposition is possible, and to provide a method of manufacturing the Cu-Ga alloy sputtering target.

### Solution to Problem

In order to solve the above problems, as a result of intensive studies by the present inventors, it was found that when heating and mixing sodium fluoride (NaF) and potassium fluoride (KF), the hygroscopic property is sufficiently improved, as compared to potassium fluoride (KF) alone. Thus, it was found that when the sodium fluoride (NaF) and the potassium fluoride (KF) are dissolved to obtain a mixture in advance, and the mixture is pulverized and used as a raw material powder, a sputtering target which has a low hygroscopic property and is resistant to discoloration can be obtained.

The present invention was conceived based on the findings described above, and according to the present invention, there is provided a Cu-Ga alloy sputtering target having a composition comprising: as a metal component, Ga in a range of 20 at% or more and 45 at% or less; K and Na in a range of 0.1 at% or more and 2 at% or less in total; and a Cu balance including inevitable impurities, in which, complex fluorides containing Na, K, and F are dispersed in a matrix of a Cu-Ga alloy, a maximum diameter of an inscribed circle of the complex fluorides is 30 µm or less, and [Na]/([Na]+[K]) is set to be in a range of 0.3 or more and 0.9 or less, [Na] and [K] being atomic ratios of Na and K in the complex fluorides, respectively.

According to the Cu-Ga alloy sputtering target having this configuration, the complex fluorides containing Na, K, and F is dispersed. Therefore, it is possible to deposit a Cu-Ga alloy film containing Na and K.

Since Na and K are dispersed as the complex fluorides containing Na, K, and F, the hygroscopic property is sufficiently low, and even when stored in the atmosphere, a surface of the sputtering target can be prevented from oxidizing and discoloring.

Since the complex fluoride is an insulator, when the maximum diameter of the inscribed circle of the complex fluorides is set to 30 µm or less, abnormal discharge caused by the complex fluorides can be prevented from occurring.

Since [Na]/([Na]+[K]) is set to be in a range of 0.3 or more in the complex fluorides, a proportion of Na is secured. Therefore, it is possible to suppress the hygroscopic property of the complex fluorides to be low and further prevent the Cu-Ga alloy sputtering target from discoloring.

Since [Na]/([Na]+[K]) is set to be in a range of 0.9 or less in the complex fluorides, a proportion of K is secured. Therefore, it is possible to deposit the Cu-Ga alloy film containing Na and K and form a solar cell with high conversion efficiency.

In the Cu-Ga alloy sputtering target of the present invention, it is preferable that an oxygen concentration is set to 1000 mass ppm or less.

In this case, since the oxygen concentration is limited to 1000 mass ppm or less, the complex fluorides containing Na, K, and F can be prevented from reacting with oxygen to form a sodium oxide and a potassium oxide having high hygroscopic properties. In addition, abnormal discharge at the time of sputtering deposition can be prevented from occurring.

According to the present invention, a method of manufacturing the Cu-Ga alloy sputtering target described above is provided which includes the steps of: a raw material powder forming step of mixing a pure Cu powder, a Cu-Ga alloy powder, and a complex fluorides powder formed of a complex fluorides containing Na, K, and F to obtain a raw material powder; a molded body forming step of forming a molded body of the raw material powder; and a sintering step of heating the molded body in a reducing atmosphere to perform pressureless sintering.

In the method of manufacturing the Cu-Ga alloy sputtering target having this configuration, the complex fluorides powder formed of the complex fluorides containing Na, K, and F. Therefore, the raw material powder can be prevented from containing an excessive amount of water due to moisture absorption. Accordingly, at the time of sintering, it can be prevented that the surface of the raw material powder is oxidized by the moisture to inhibit sinterability, and the sinterability can be improved.

In the manufacturing method, since pure Cu powder which is likely to be plastically deformed is used, the shape can be maintained when a molded body is formed.

In the above manufacturing method, since the Cu-Ga alloy powder is used, when controlling a sintering temperature, a liquid phase can be generated at the time of sintering, and a relative density of a sintered material can be increased.

In the manufacturing method, since the pressureless sintering is performed, the liquid phase can be prevented from leaking out of the molded body, and the sintering can be favorably performed.

### Advantageous Effects of Invention

According to the present invention, it is possible to provide a Cu-Ga alloy sputtering target in which Na and K are contained, and even when stored in an atmosphere, discoloration is suppressed, and stable sputtering deposition is possible, and a method of manufacturing the Cu-Ga alloy sputtering target.

### BRIEF DESCRIPTION OF DRAWINGS

FIG. 1 is a schematic view illustrating a Cu-Ga alloy sputtering target according to an embodiment of the present invention.
FIG. 2 is an element mapping image by EPMA of Cu-Ga alloy sputtering target according to another embodiment of the present invention.
FIG. 3 is a flow diagram showing a method of manufacturing a Cu-Ga alloy sputtering target, which is the present embodiment.
FIG. 4 is a diagram of a binary phase of NaF and KF.
FIG. 5 is a schematic view illustrating diagram a Cu-Ga alloy sputtering target according to still an embodiment of the present invention.
FIG. 6 is a schematic view illustrating a Cu-Ga alloy sputtering target according to an embodiment of the present invention. FIG. 6(a) is a sectional view orthogonal to an axis O direction, and FIG. 6(b) is a sectional view along the axis O.
FIG. 7 is a photograph showing an example of results of discoloration tests in Example. FIG. 7(a) is a material evaluated as A, which has no discoloration, FIG. 7(b) is a material evaluated as B, which has discoloration (little), and FIG. 7(c) is a material evaluated as C, which has discoloration (large).

### BEST MODE FOR CARRYING OUT THE INVENTION

Hereinafter, a Cu-Ga alloy sputtering target and a method of manufacturing the Cu-Ga alloy sputtering target according to embodiments of the present invention will be described with reference to accompanying drawings.

The Cu-Ga alloy sputtering target according to the present embodiment is used when depositing a Cu-Ga film by sputtering, in order to form a light absorption layer formed of a CIGS film in a CIGS thin film solar cell.

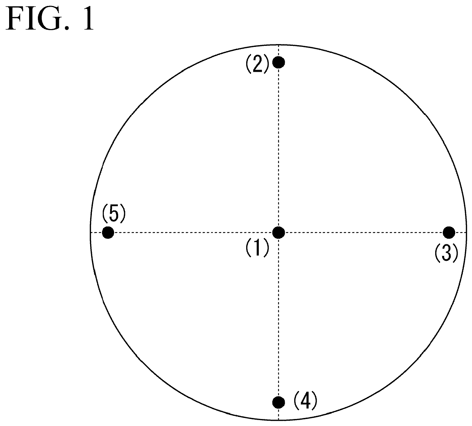

The Cu-Ga alloy sputtering target according to the present embodiment having a composition comprising: as a metal component, Ga in a range of 20 at% or more and 45 at% or less; K and Na in a range of 0.1 at% or more and 2 at% or less in total; and a Cu balance including inevitable impurities. In the present embodiment, as shown in FIG. 1, a disk-shaped sputtering target having a circular sputtering surface is used.

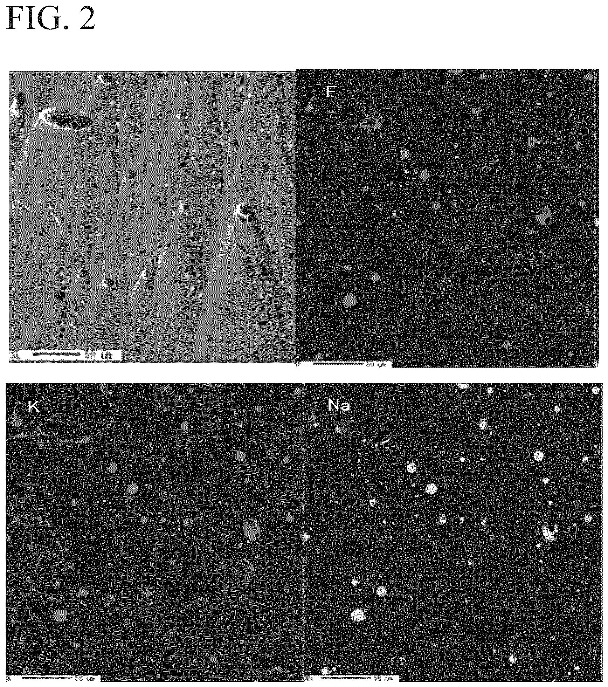

In the Cu-Ga alloy sputtering target according to the present embodiment, as shown in FIG. 2, in the matrix of Cu-Ga alloy, the complex fluorides containing Na, K, and F is dispersed and a maximum diameter of an inscribed circle of the complex fluorides is set to 30 µm or less.

[Na]/([Na]+[K]) is set to be in a range of 0.3 or more and 0.9 or less, [Na] and [K] being atomic ratios of Na and K in the complex fluorides, respectively.

In the Cu-Ga alloy sputtering target of the present embodiment, the oxygen concentration is set to 1000 mass ppm or less.

In the Cu-Ga alloy sputtering target of the present embodiment, the relative density is set to 90% or higher.

Hereinafter, in the Cu-Ga alloy sputtering target of the present embodiment, reason for specifying, a total content (at%) of K and Na, a tissue, the maximum diameter of the inscribed circle of the complex fluorides, the atomic ratio [Na]/([Na]/]+[K]) of the complex fluorides, the oxygen concentration, and the relative density, as above will be shown.

### (Total Content of K and Na)

When K and Na which are alkali metals are contained in a CIGS film to be a light absorption layer of a solar cell, these have an operational effect of improving a conversion efficiency of the solar cell.

In the Cu-Ga alloy sputtering target according to the present embodiment, in a case where the total content of K and Na is less than 0.1 at%, there was a problem that the operational effect might not be achieved.

On the other hand, in the Cu-Ga alloy sputtering target according to the present embodiment, in a case where the total content of K and Na exceeds 2 at%, the alkali salt is excessively contained. Accordingly, the hygroscopic property cannot be suppressed to be low. In addition, there was a concern that the surface of the sputtering target might be oxidized and discolored when stored in the atmosphere.

Therefore, in the present embodiment, the total content of K and Na is set to be in the range of 0.1 at% or more and 2 at% or less.

In order to surely improve the conversion efficiency of the solar cell, a lower limit of the total content of K and Na is preferably 0.2 at% or more, and more preferably 0.3 at% or more. In addition, in order to suppress the hygroscopic property and prevent discoloration from occurring, an upper limit of the total content of K and Na is preferably 1.5 at% or less, and more preferably 1.2 at% or less.

### (Complex fluorides)

Since the complex fluorides containing Na, K, and F has hygroscopic property lower than that of the potassium fluoride (KF), even when stored in the atmosphere, the surface of the sputtering target can be prevented from oxidizing and discoloring.

The complex fluorides containing Na, K, and F can be confirmed when in an element mapping image obtained by a wavelength separation type X-ray detector of an electron probe micro analyzer (EPMA), there is a region where Na, K, and F coexist in a substrate of the Cu-Ga alloy.

### (Maximum Diameter of Inscribed Circle of Complex fluorides)

The complex fluorides containing Na, K, and F described above is an insulator. Therefore, when a particle diameter of the complex fluorides is large, abnormal discharge is likely to occur at the time of sputtering deposition.

Thus, in the present embodiment, the maximum diameter of the inscribed circle of the complex fluorides containing Na, K, and F is limited to 30 µm or less.

In the present embodiment, as shown in FIG. 1, samples were taken from 5 sites of a center (1) of the circle that the sputtering surface forms, and outer peripheral portions (2), (3), (4), and (5), on two straight lines which pass through the center of the circle and orthogonal to each other. A tissue of the samples was observed at a magnification of 360 times. The observation was performed in 3 fields of view for one sample, and the maximum diameter of the inscribed circle of the complex fluorides was measured in 15 fields of view in total.

In order to further suppress abnormal discharge at the time of sputtering deposition, the maximum diameter of the inscribed circle of the complex fluorides containing Na, K, and F is preferably set to 30 µm or less, and more preferably set to 20 µm or less.

### (Atomic Ratio of Complex fluorides [Na]/([Na]+[K]))

In the complex fluorides described above, [Na]/([Na]+[K]) is set to be in a range of 0.3 or more, [Na] and [K] being atomic ratios of Na and K in the complex fluorides, respectively. Accordingly, a proportion of Na in the complex fluorides is secured.

And it is possible to suppress the hygroscopic property of the complex fluorides to be low.

On the other hand, [Na]/([Na]+[K]) is set to be in a range of 0.9 or less, [Na] and [K] being atomic ratios of Na and K in the complex fluorides, respectively.

Accordingly, a proportion of K in the complex fluorides is secured. And it is possible to surely deposit the Cu-Ga alloy film containing Na and K and form a solar cell with high conversion efficiency.

In order to suppress the hygroscopic property and prevent discoloration from occurring, a lower limit of [Na]/([Na]+[K]) is preferably 0.35 or more, and more preferably 0.45 or more. In addition, in order to further surely deposit the Cu-Ga alloy containing Na and K, an upper limit of [Na]/([Na]+[K]) is preferably 0.8 or less, and more preferably 0.7 or less.

### (Oxygen Concentration)

When the complex fluorides described above reacts with oxygen, there is a concern that a sodium oxide or a potassium oxide having high hygroscopic property may be formed.

For this reason, in the present embodiment, the oxygen concentration in the Cu-Ga alloy sputtering target is limited to 1000 mass ppm or less. Accordingly, formation of the sodium oxide or the potassium oxide having high hygroscopic property is suppressed.

In order to further suppress the formation of the sodium oxide or the potassium oxide having high hygroscopic property, the oxygen concentration in the Cu-Ga alloy sputtering target is preferably 900 mass ppm or less, and more preferably 800 mass ppm or less.

### (Relative Density)

In the Cu-Ga alloy sputtering target of the present embodiment, the relative density is set to 90% or more. Accordingly, the number of voids in the Cu-Ga alloy sputtering target can be reduced, and the abnormal discharge at the time of sputtering deposition can be prevented from occurring.

In order to further prevent the abnormal discharge caused by voids from occurring, the relative density of the Cu-Ga alloy sputtering target is preferably 93% or higher, and more preferably 95% or higher.

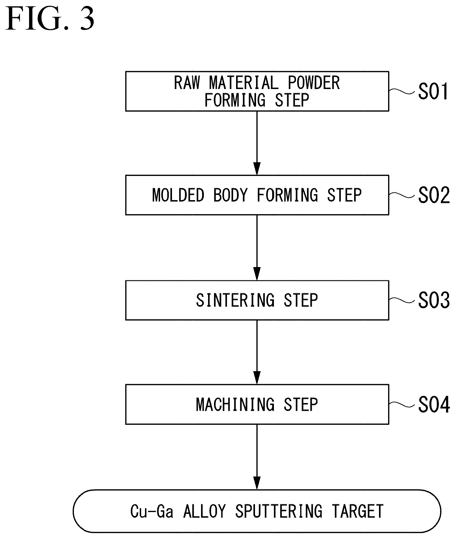

Next, a method of manufacturing the Cu-Ga alloy sputtering target according to embodiments will be described with reference to FIG. 3.

### (Raw Material Powder Forming Step S01)

First, a pure copper powder, a Cu-Ga alloy powder, and a complex fluorides powder formed of the complex fluorides containing Na, K, and F are prepared.

In the pure copper powder, a median diameter D50 measured by micro track is 2 to 3 µm.

The Cu-Ga alloy powder is manufactured by an atomization method, and a median diameter D50 measured by micro track is 20 to 30 µm. In the Cu-Ga alloy powder, it is preferable that a Ga content is set to be in a range of 45 at% or more and 49 at% or less.

The complex fluorides powder formed of the complex fluorides containing Na, K, and F was manufactured as follows.

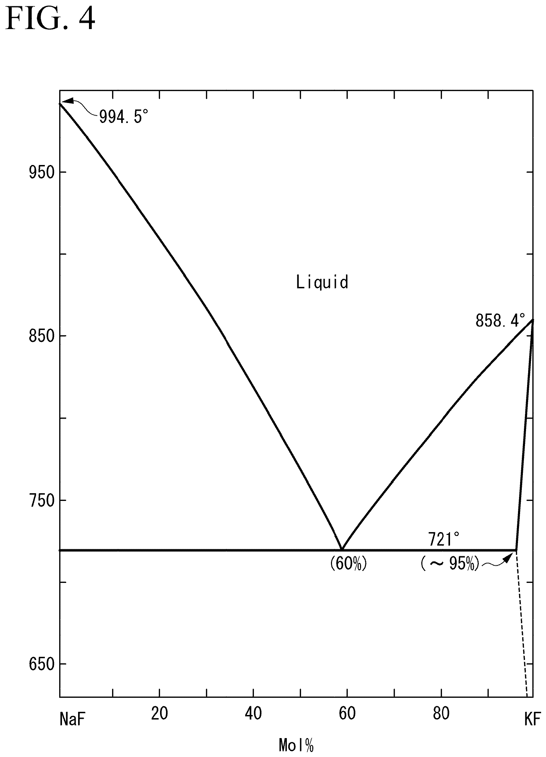

First, NaF and KF are weighed to have a predetermined composition, and heated and melted in an inert gas atmosphere to manufacture a mass of the complex fluorides containing Na, K, and F. NaF and KF undergo eutectic reaction as shown in FIG. 4. The resulting mass of the complex fluorides is pulverized and sieved to have a maximum particle size of 20 µm or less, and the complex fluorides powder described above was obtained.

The pure copper powder, the Cu-Ga alloy powder, and the complex fluorides powder described above are weighed to have a predetermined composition, and mixed in an inert atmosphere (Ar atmosphere) using a mixing apparatus such as a Henschel mixer to obtain the raw material powder.

It is preferable that the pure copper powder is contained in a range of 3 mol% or more and 60 mol% or less of a whole raw material powder.

### (Molded Body Forming Step S02)

Next, a green compact (a molded body) was formed using the raw material powder obtained as described above, at 500 kgf/cm² to 2000 kgf/cm² of molding pressure.

### (Sintering Step S03)

Next, the molded body obtained as described above is charged into a sintering furnace, heated in a pressureless state at a temperature rising rate of 10°C/min to reach a predetermined sintering temperature, while flowing a reducing gas such as hydrogen, carbon monoxide, and ammonia decomposition gas in a range of 10 L/min or more and 100 L/min or less, and held at the sintering temperature for 5 hours. Then, it was naturally cooled in the sintering furnace to obtain a sintered material.

It is preferable that the sintering temperature is set according to the Ga content in the Cu-Ga alloy powder.

### (Machining Step S04)

Next, the sintered material described above is machined on a lathe to obtain a Cu-Ga alloy sputtering target having a predetermined size.

As described above, the Cu-Ga alloy sputtering target according to the present embodiment is manufactured.

According to the Cu-Ga alloy sputtering target having the configuration as above, according to the present embodiment, the complex fluorides containing Na, K, and F is dispersed in the matrix of the Cu-Ga alloy. Therefore, it is possible to deposit the Cu-Ga alloy film containing Na and K by sputtering deposition using the Cu-Ga alloy sputtering target. Accordingly, a solar cell having high conversion efficiency can be configured.

Then, since Na and K are dispersed as the complex fluorides containing Na, K, and F, the hygroscopic property is sufficiently lower than that of the potassium fluoride (KF), and even when stored in the atmosphere, the surface of the Cu-Ga alloy sputtering target can be prevented from oxidizing and discoloring. In addition, at the time of sputtering deposition, abnormal discharge caused by an oxide can be prevented from occurring. Furthermore, since the maximum diameter of the inscribed circle of the complex fluorides, which is an insulator, is limited to 30 µm or less, at the time of sputtering deposition, abnormal discharge caused by the complex fluorides can be prevented from occurring.

Accordingly, it becomes possible to stably perform sputtering deposition.

In the Cu-Ga alloy sputtering target according to the present embodiment, [Na]/([Na]+[K]) is set to be in a range of 0.3 or more, [Na] and [K] being atomic ratios of Na and K in the complex fluorides, respectively. Therefore, a proportion of Na in the complex fluorides is secured. And it is possible to suppress the hygroscopic property of the complex fluorides surely to be low and further prevent the Cu-Ga alloy sputtering target from discoloring.

In the Cu-Ga alloy sputtering target according to the present embodiment, [Na]/([Na]+[K]) is set to be in a range of 0.9 or less, [Na] and [K] being atomic ratios of Na and K in the complex fluorides, respectively. Therefore, a proportion of K in the complex fluorides is secured. And it is possible to deposit the Cu-Ga alloy film containing Na and K and form a solar cell with high conversion efficiency.

In the Cu-Ga alloy sputtering target according to the present embodiment, since the oxygen concentration is limited to 1000 mass ppm or less, the complex fluorides containing Na, K, and F can be prevented from reacting with oxygen to form a sodium oxide and a potassium oxide having high hygroscopic property, and it is possible to further prevent the Cu-Ga alloy sputtering target from discoloring. At the time of sputtering deposition, abnormal discharge caused by the oxide described above can be prevented from occurring.

In the Cu-Ga alloy sputtering target according to the present embodiment, the relative density is set to 90% or more. Therefore, the number of voids in the Cu-Ga alloy sputtering target can be reduced, and the abnormal discharge at the time of sputtering deposition can be prevented from occurring.

In the method of manufacturing the Cu-Ga alloy sputtering target according to the embodiment, the complex fluorides powder formed of the complex fluorides containing Na, K, and F is used as the raw material powder, and the raw material powder can be prevented from containing an excessive amount of water due to moisture absorption. Accordingly, at the time of sintering, the surface of the raw material powder can be prevented from being oxidized by the moisture to inhibit sinterability, and the sinterability can be improved.

In the manufacturing method according to the present embodiment, the pure Cu powder which is likely to be plastically deformed is used as the raw material powder. Therefore, in the molded body forming step S02, a shape of the molded body can be easily maintained.

In the manufacturing method according to the present embodiment, the Cu-Ga alloy powder is used as the raw material powder. Therefore, the relative density of the sintered material can be increased by adjusting the sintering temperature according to the Ga content of the Cu-Ga alloy powder.

In the manufacturing method according to the present embodiment, since the pressureless sintering is performed in the sintering step S03, the formed liquid phase can be prevented from leaking out of the molded body, and the sintering can be favorably performed.

Hereinbefore, a description has been given of the embodiments of the present invention. However, the present invention is not limited thereto, and approximate modifications can be made in a range not departing from the technical spirit of the invention.

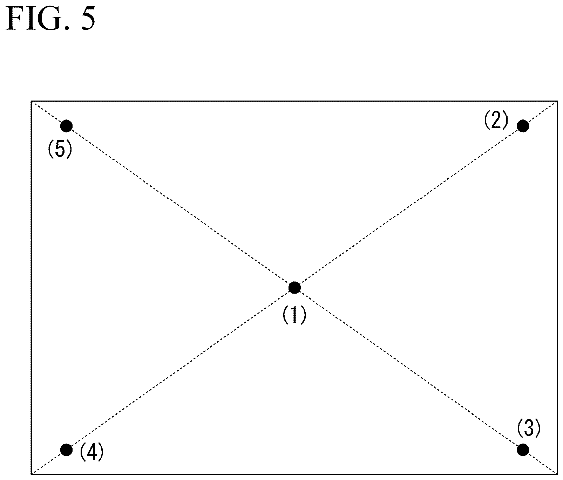

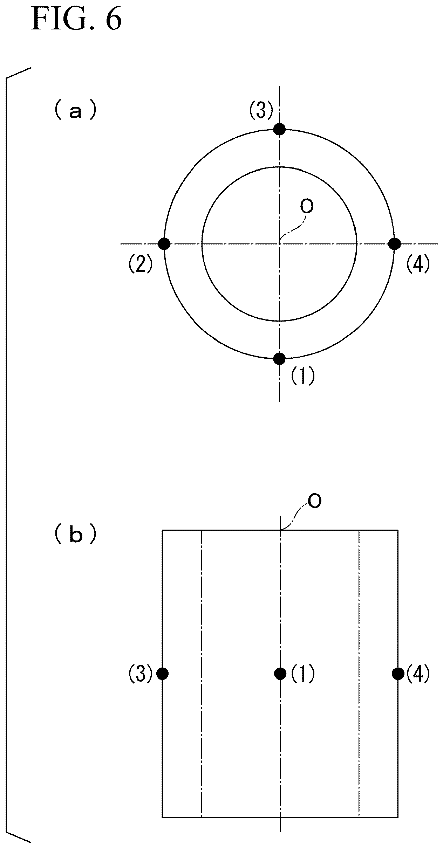

For example, in the present embodiment, as shown in FIG. 1, a description was given of the disk-shaped sputtering target having a circular sputtering surface. However, there is no limitation. As shown in FIG. 5, a rectangular flat sputtering target having a rectangular sputtering surface may be used. In addition, as shown in FIG. 6, a cylindrical-shaped sputtering target having a cylindrical sputtering surface may also be used.

In the rectangular flat sputtering target having the rectangular sputtering surface, as shown in FIG. 5, it is preferable that samples were taken from 5 sites of an intersection (1) where diagonals intersect to each other and corners (2), (3), (4), and (5) on each diagonal, a tissue of the samples was observed at a magnification of 360 times, the observation was performed in 3 fields of view for one sample, and the maximum diameter of the inscribed circle of the complex fluorides was measured in 15 fields of view in total.

In the cylindrical sputtering target having the cylindrical sputtering surface, as shown in FIG. 6, it is preferable that samples were taken from 4 sites, (1), (2), (3), and (4), at equal intervals (90° intervals) in a circumferential direction in the center portion of an axial direction, a tissue of the samples was observed at a magnification of 360 times, the observation was performed in 3 fields of view for one sample, and the maximum diameter of the inscribed circle of the complex fluorides was measured in 12 fields of view in total.

### EXAMPLES

Hereinafter, results of an evaluation test which was obtained by evaluating the Cu-Ga alloy sputtering target and the method of manufacturing the Cu-Ga alloy sputtering target according to the present invention described above will be described.

A complex fluorides formed of a pure copper powder (a median diameter: 3 µm, purity: 99.9 mass% or more), a Cu-Ga alloy atomized powder (median diameter: 25 µm) having a composition shown in Table 1, and a complex fluorides containing Na, K, and F having a composition shown in Table 1 was prepared. In addition, a NaF powder (median diameter 8µm) and KF powder (median diameter 5 µm) to be used as comparative examples were prepared.

In the complex fluorides powder, NaF and KF were weighed to have a predetermined composition, and heated and melted in an Ar gas atmosphere to manufacture a mass of the complex fluorides containing Na, K, and F. The mass was pulverized and sieved.

The pure copper powder, the Cu-Ga alloy atomized powder, the complex fluorides powder, NaF powder, and KF powder described above were weighed to satisfy a mixing ratio shown in Table 2, and mixed in an Ar atmosphere using a Henschel mixer to obtain the raw material powder.

A mold is filled with the raw material powder described above and pressed at a molding pressure of 1000 kgf/cm² to obtain a disc-shaped molded body.

The molded body was placed in a firing furnace and sintered under conditions shown in Table 2. The temperature rising rate is set to 10°C/min to reach a sintering temperature. The sintering temperature was kept for 5 hours, and then naturally cooled in the furnace. Accordingly, the sintered material was obtained.

The resulting sintered material was machined to manufacture a disc-shaped Cu-Ga alloy sputtering target having a diameter of 125 mm and a thickness of 6 mm.

In addition, the resulting Cu-Ga alloy sputtering target was evaluated on the following items. Evaluation results are shown in Table 3.

### (Content of Metal Component)

The prepared Cu-Ga alloy sputtering target was pulverized and pretreated with acid. Then, a composition analysis of Ga, K, and Na was performed by ICP-AES. The Cu component was described as a balance excluding Ga, K, and Na.

### (Complex fluorides Containing Na, K, and F)

The complex fluorides containing Na, K, and F was confirmed when in an element mapping image obtained by a wavelength separation type X-ray detector of an electron probe micro analyzer (EPMA: JXA-8530F manufactured by JEOL Ltd.), there is a region where Na, K, and F coexist in a substrate of the Cu-Ga alloy.

In the present example, as shown in FIG. 1, samples were taken from 5 sites of a center (1) of the circle, and outer peripheral portions (2), (3), (4), and (5), on two straight lines which pass through the center of the circle and orthogonal to each other. A tissue of the samples was observed at a magnification of 360 times. The observation was performed in 3 fields of view for one sample, and the maximum diameter of the inscribed circle of the complex fluorides was measured in 15 fields of view in total.

The atomic ratio [Na] of Na and the atomic ratio [K] of K in the complex fluorides were observed at an accelerating voltage of 15 kV using an electron probe micro analyzer (EPMA: JXA-8530F manufactured by JEOL Ltd.). The compositional analysis of the exposed complex fluorides was carried out by ion processing the section of the samples to measure a content of K and Na in the complex fluorides.

Similar to the maximum diameter of the inscribed circle of the complex fluorides described above, contents of K and Na in the complex fluorides were measured in a total of 15 fields of view, and an average value of these was determined.

### (Oxygen Concentration)

Regarding analysis of O (oxygen), a measurement was performed by an infrared absorption method described in "JIS Z 2613" General Method of Determination of Oxygen in Metallic Materials".

### (Relative Density)

In a graph of the Ga content and the density, a density of pure copper ρ_{Cu}=8.96g/cm³ and a density of Cu-Ga alloy (Cu: 69.23 at%, Ga: 30.77 at%) ρ_{CuGa}=8.47g/cm³ were connected by a straight line, and according to the composition (Ga content) of the Cu-Ga alloy, a value determined by interpolation or extrapolation was used as a reference value. Based on this, according to an addition amount of the NaF (theoretical density 2.79 g/cm³ ) and KF (theoretical density 2.48 g/cm³), a theoretical density was calculated.

Then, a weight of the Cu-Ga alloy sputtering target obtained by machining was measured, and the weight was divided by a volume determined from the shape. In this manner, the density was measured. A ratio between the measured density and the theoretical density described above was calculated to determine a relative density.

### (Discoloration)

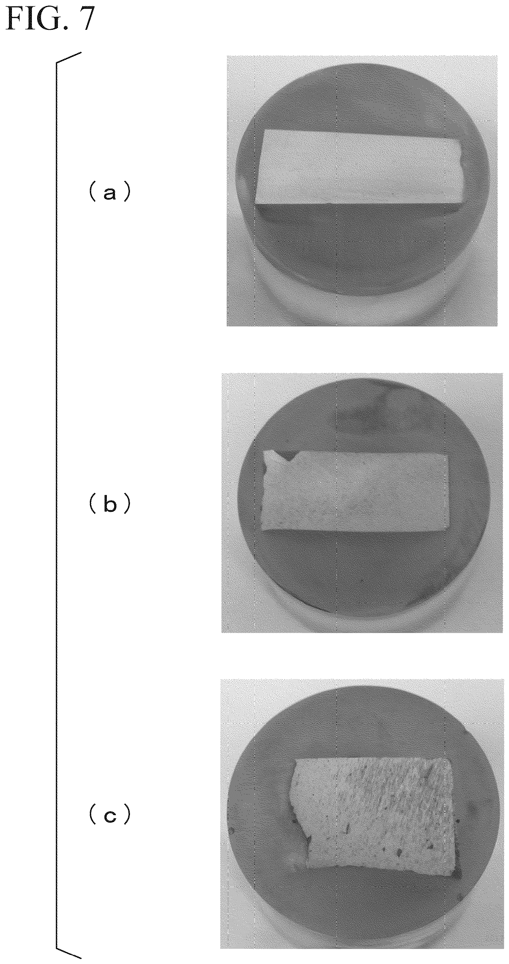

In a room at a temperature of 22±2°C and a relative humidity of 60±5%, a surface of resin-filled sample was dry-polished using a No. 2000 emery abrasive paper. Thereafter, it was stored for 8 hours in the same room, and an appearance change was visually observed. As shown in FIG. 7(a), those in which no discoloration was recognized was evaluated as "A". As shown in FIG. 7(b), those in which small discoloration was recognized was evaluated as "B". As shown in FIG. 7 (c), those in which large discoloration was recognized was evaluated as "C".

### (Abnormal Discharge)

The prepared Cu-Ga alloy sputtering target was soldered to a backing plate made of Cu using In solder. Then, sputtering deposition was performed under the following conditions, and the number of occurrences of abnormal discharge was measured. In order to remove a surface defect of the Cu-Ga alloy sputtering target, pre-sputtering was carried out under the following conditions. Thereafter, the number of abnormal discharges was measured.
Sputtering method: DC magnetron sputtering
Achieved vacuum degree: 4×10⁻⁴ Pa or less
Sputtering Ar pressure: 0.4 Pa
Pre-sputtering power: 150 Wh
Sputtering power: 300 W
Measurement of abnormal discharge: Micro Arc Monitor manufactured by Landmark Technology
Measurement time: 2 hours continuous discharge

**[Table 1]**

| | | Complex fluorides powder | | Cu-Ga alloy powder | | |
|---|---|---|---|---|---|---|
| | | Atomic ratio [Na]/([Na]+[K]) | Maximum diameter (µm) | Ga (at%) | Cu | Liquid phase appearance temperature (°C) |
| Invention Example | 1 | 0.31 | 18 | 48.5 | Balance | 254 |
| | 2 | 0.40 | 15 | 48.5 | Balance | 254 |
| | 3 | 0.45 | 18 | 47.8 | Balance | 254 |
| | 4 | 0.50 | 15 | 49.0 | Balance | 254 |
| | 5 | 0.88 | 20 | 48.0 | Balance | 254 |
| | 6 | 0.62 | 20 | 46.5 | Balance | 254 |
| | 7 | 0.70 | 15 | 45.2 | Balance | 254 |
| | 8 | 0.51 | 20 | 46.0 | Balance | 254 |
| Comparative Example | 1 | 0.24 | 15 | 43.0 | Balance | 254 |
| | 2 | 0.38 | 38 | 47.8 | Balance | 254 |
| | 3 | 0.50 | 17 | 49.0 | Balance | 254 |
| | 4 | 0.45 | 24 | 40.5 | Balance | 360 |

**[Table 2]**

| | | Mixing ratio of raw materials (mol%) | | | | | Sintering step | |
|---|---|---|---|---|---|---|---|---|
| | | Pure copper powder | Cu-Ga alloy powder | Complex fluorides powder | NaF powder | KF powder | Sintering temperature (°C) | Atmosphere |
| Invention Example | 1 | 56.7 | 43.2 | 0.1 | - | - | 800 | Hydrogen |
| | 2 | 47.7 | 51.9 | 0.4 | - | - | 800 | Hydrogen |
| | 3 | 57.8 | 41.7 | 0.5 | - | - | 830 | Carbon monoxide |
| | 4 | 37.0 | 62.5 | 0.5 | - | - | 800 | Ammonia decomposition gas |
| | 5 | 26.5 | 72.4 | 1.1 | - | - | 800 | Hydrogen |
| | 6 | 30.2 | 68.4 | 1.5 | - | - | 810 | Hydrogen |
| | 7 | 9.6 | 88.6 | 1.8 | - | - | 800 | Ammonia decomposition gas |
| | 8 | 3.2 | 94.8 | 2.0 | - | - | 820 | Hydrogen |
| Comparative Example | 1 | 48.2 | 50.3 | 1.5 | - | - | 800 | Ammonia decomposition gas |
| | 2 | 46.8 | 52.1 | 1.1 | - | - | 810 | Hydrogen |
| | 3 | 38.5 | 60.5 | - | 0.50 | 0.50 | 800 | Hydrogen |
| | 4 | 13.3 | 84.4 | 2.3 | - | - | 810 | Carbon monoxide |

**[Table 3]**

| | | Metal components of target (at%) | | | | Complex fluorides | | | Oxygen concentration (mass ppm) | Relative density (%) | Discoloration test | Number of abnormal discharges (times) |
|---|---|---|---|---|---|---|---|---|---|---|---|---|
| | | Ga | Na | K | Cu | Present or Absent | Maximum diameter of inscribed circle (µm) | Atomic ratio [Na]/([Na]+[K]) | | | | |
| Invention Example | 1 | 21.0 | 0.03 | 0.07 | Balance | Present | 15 | 0.30 | 850 | 91 | A | 10 |
| | 2 | 25.3 | 0.16 | 0.24 | Balance | Present | 16 | 0.35 | 740 | 93 | A | 5 |
| | 3 | 20.1 | 0.23 | 0.28 | Balance | Present | 22 | 0.46 | 630 | 98 | A | 0 |
| | 4 | 30.8 | 0.25 | 0.25 | Balance | Present | 23 | 0.49 | 720 | 96 | A | 10 |
| | 5 | 35.2 | 0.97 | 0.13 | Balance | Present | 15 | 0.89 | 710 | 97 | A | 12 |
| | 6 | 32.3 | 0.93 | 0.57 | Balance | Present | 28 | 0.63 | 810 | 98 | A | 3 |
| | 7 | 40.8 | 1.26 | 0.54 | Balance | Present | 21 | 0.71 | 750 | 99 | A | 0 |
| | 8 | 44.9 | 1.02 | 0.98 | Balance | Present | 20 | 0.50 | 990 | 95 | A | 8 |
| Comparative Example | 1 | 22.1 | 0.36 | 1.14 | Balance | Present | 25 | 0.22 | 1200 | 88 | B | 70 |
| | 2 | 25.3 | 0.42 | 0.68 | Balance | Present | 35 | 0.36 | 790 | 92 | A | 55 |
| | 3 | 30.0 | 0.50 | 0.50 | Balance | Absent | 18 | 0.52 | 1500 | 89 | C | 110 |
| | 4 | 35.0 | 1.04 | 1.27 | Balance | Present | 25 | 0.47 | 1100 | 82 | C | 153 |

In Comparative Example 1 in which [Na]/([Na]+[K]) in the complex fluorides was 0.22, the oxygen concentration was high as 1200 mass ppm, the relative density was low, 88%, and the discoloration test result was "B". In addition, the number of abnormal discharges at the time of sputtering deposition was large as 70 times. It is presumed that a K content is relatively large and the hygroscopic property cannot be sufficiently suppressed, and the sinterability was lowered.

In Comparative Example 2 in which the maximum diameter of the inscribed circle of the complex fluorides was 35 µm, the number of abnormal discharges at the time of sputtering deposition was high as 55 times. It is presumed that the particle diameter of the complex fluorides which was the insulator was large, and abnormal discharge caused by the complex fluorides occurred.

In Comparative Example 3 in which the NaF powder and the KF powder were added respectively alone and the complex fluorides was not contained, the oxygen concentration was high as 1500 mass ppm, the relative density was low as 89%, and the discoloration test result was "C". In addition, the number of abnormal discharges at the time of sputtering deposition was large as 110 times. It is presumed that since the KF is present alone, the hygroscopic property cannot be sufficiently suppressed, and the sinterability was lowered.

In Comparative Example 4 in which the total content of Na and K was 2.31 at% or more, the oxygen concentration was high as 1100 mass ppm, the relative density was low as 82%, and the discoloration test result was "C". In addition, the number of abnormal discharges at the time of sputtering deposition was large as 153 times. It is presumed that since Na and K were excessively contained, the hygroscopic property could not be sufficiently suppressed, and the sinterability was lowered.

On the contrary, in Invention Examples 1 to 8, the oxygen concentration was 1000 mass ppm or less, and the relative density was 90% or higher. In addition, the discoloration test results were all "A", and the number of abnormal discharges at the time of sputtering deposition was reduced to 12 or less.

From the above, according to Invention Examples, it was confirmed that it is possible to provide a Cu-Ga alloy sputtering target in which even when stored in the atmosphere, discoloration is suppressed, and stable sputtering deposition is possible.

### Industrial Applicability

According to the present invention, it is possible to provide a Cu-Ga alloy sputtering target in which Na and K are contained, and even when stored in an atmosphere, discoloration is suppressed, and stable sputtering deposition is possible, and a method of manufacturing the Cu-Ga alloy sputtering target.

## Claims

1. A Cu-Ga alloy sputtering target having a composition comprising: as a metal component, Ga in a range of 20 at% or more and 45 at% or less; K and Na in a range of 0.1 at% or more and 2 at% or less in total; and a Cu balance including inevitable impurities, wherein
complex fluorides containing Na, K, and F are dispersed in a matrix of a Cu-Ga alloy,
a maximum diameter of an inscribed circle of the complex fluorides is 30 µm or less, and
[Na]/([Na]+[K]) is set to be in a range of 0.3 or more and 0.9 or less, [Na] and [K] being atomic ratios of Na and K in the complex fluorides, respectively.

2. The Cu-Ga alloy sputtering target according to claim 1, wherein an oxygen concentration is set to 1000 mass ppm or less.

3. A method of manufacturing the Cu-Ga alloy sputtering target according to claim 1 or 2, the method comprising the steps of:
a raw material powder forming step of mixing a pure Cu powder, a Cu-Ga alloy powder, and a complex fluorides powder formed of a complex fluorides containing Na, K, and F to obtain a raw material powder;
a molded body forming step of forming a molded body of the raw material powder; and
a sintering step of heating the molded body in a reducing atmosphere to perform pressureless sintering.

## Patentansprüche

1. Cu-Ga-Legierungs-Sputtertarget mit einer Zusammensetzung, die folgendes umfasst: Ga in einem Bereich von 20 At.-% oder mehr und 45 At.-% oder weniger als eine Metallkomponente; K und Na in einem Bereich von 0,1 At.-% oder mehr und 2 At.-% oder weniger insgesamt; und einen Cu-Rest einschließlich unvermeidbarer Verunreinigungen, wobei
komplexe Fluoride, die Na, K und F enthalten, in einer Matrix einer Cu-Ga-Legierung dispergiert sind,
ein maximaler Inkreis-Durchmesser der komplexen Fluoride 30 µm oder weniger beträgt, und
[Na]/([Na]+[K]) auf einen Bereich von 0,3 oder mehr und 0,9 oder weniger eingestellt ist, wobei [Na] und [K] Atomverhältnisse von Na bzw. K in den komplexen Fluoriden sind.

2. Cu-Ga-Legierungs-Sputtertarget gemäß Anspruch 1, wobei eine Sauerstoffkonzentration auf 1000 Massen-ppm oder weniger eingestellt ist.

3. Verfahren zur Herstellung des Cu-Ga-Legierungs-Sputtertargets gemäß Anspruch 1 oder 2, wobei das Verfahren die folgenden Schritte umfasst:
einen Rohmaterialpulver-Bildungsschritt, in dem ein reines Cu-Pulver, ein Cu-Ga-Legierungspulver und ein Pulver aus komplexen Fluoriden, die Na, K und F enthalten, so gemischt werden, dass ein Rohmaterialpulver erhalten wird;
einen Formkörper-Bildungsschritt, in dem ein Formkörper aus dem Rohmaterialpulver gebildet wird; und
einen Sinterschritt, in dem der Formkörper so in einer reduzierenden Atmosphäre erwärmt wird, dass druckloses Sintern durchgeführt wird.

## Revendications

1. Cible de pulvérisation en alliage Cu-Ga présentant une composition comprenant :
en tant que composant métallique, du Ga en une quantité de 20 % en atomes ou plus et 45 % en atomes ou moins ; du K et du Na en une quantité totale de 0,1 % en atomes ou plus et 2 % en atomes ou moins ; et un reste de Cu incluant des impuretés inévitables, dans laquelle
des fluorures complexes contenant du Na, du K et du F sont dispersés dans une matrice d'un alliage Cu-Ga,
un diamètre maximal d'un cercle inscrit des fluorures complexes est de 30 µm ou moins, et
[Na]/([Na]+[K]) est compris en une quantité de 0,3 ou plus et de 0,9 ou moins, [Na] et [K] étant des rapports atomiques de Na et de K dans les fluorures complexes, respectivement.

2. Cible de pulvérisation en alliage Cu-Ga selon la revendication 1, dans laquelle une concentration en oxygène est fixée à 1000 ppm en masse ou moins.

3. Procédé de fabrication de la cible de pulvérisation en alliage Cu-Ga selon la revendication 1 ou 2, le procédé comprenant les étapes suivantes :
une étape de formation de poudre de matière première consistant à mélanger une poudre de Cu pur, une poudre d'alliage Cu-Ga et une poudre de fluorures complexes formée de fluorures complexes contenant du Na, du K et du F pour obtenir une poudre de matière première ;
une étape de formation de corps moulé consistant à former un corps moulé de la poudre de matière première ; et
une étape de frittage consistant à chauffer le corps moulé dans une atmosphère réductrice pour effectuer un frittage sans pression.
